# DEMANDE DE BREVET EUROPEEN

(11) **EP 0 594 500 A1**
(43) Date de publication de la demande: **27.04.1994**
(21) Numéro de dépôt: 93402570.1
(22) Date de dépôt: 19.10.1993
(51) Int. Cl.: G01R 15/02, G01R 15/07

(54) **Dispositif de mesure de courant par shunt**

(30) Priorité: 21.10.1992 FR 9212592
(71) Demandeur: SAGEM SA, F-75783 Paris Cédex 16 (FR)
(72) Inventeur: Pradel, Denis, F-95480 Pierrelaye (FR)
(74) Mandataire: Fort, Jacques

(57) **Abrégé**

Le dispositif, utilisable notamment pour mesurer de façon précise des courants très variables sur un circuit flottant, comprend un shunt (10) et de plus un convertisseur tension-déphasage (16) fournissant deux signaux alternatifs dont le déphase est représentatif de la tension, un coupleur opto-électronique (20) d'isolement galvanique et de transmission des signaux et un convertisseur déphasage-tension (26) fournissant une tension de sortie représentative du déphasage.

## Description

L'invention a pour objet un dispositif de mesure de courant électrique, fournissant une tension de sortie proportionnelle au courant parcourant un conducteur électrique, du type dit "flottant", c'est-à-dire dont la sortie est isolée du conducteur électrique de sorte qu'il n'est pas soumis aux variations de potentiel de ce dernier.

L'invention trouve une application dans de nombreux domaines industriels, tels que la robotique, la régulation de courant dans un moteur et même le comptage précis de l'énergie électrique consommée, à partir de la mesure de la tension et de l'intensité. A titre d'exemples, on peut citer la mesure du courant très variable qui traverse les moteurs couples à commutation électronique fréquemment utilisés en robotique, et les asservissements à valeur moyenne de courant nulle.

A l'heure actuelle on utilise surtout, pour mesurer le courant traversant un circuit à potentiel variable, alternatif ou continu, des capteurs à circuit magnétique ayant des sondes de mesure de flux dans l'entrefer. Le flux y est asservi à une valeur nulle pour pallier le défaut de linéarité de la réponse. Ces capteurs sont coûteux.

On a également proposé des dispositifs de comptage ayant un shunt résistif, qui a l'avantage d'être un capteur économique, fournissant une tension d'entrée proportionnelle au courant à mesurer. Les dispositifs connus de ce genre ont une précision et une linéarité insuffisantes pour beaucoup d'applications.

On connaît par ailleurs des déphaseurs commandés par une tension (US-A-2 758 219) et des coupleurs opto-électroniques (Boucher, "fibres optiques en H.T., un potentiel qui fait la différence", Mesures régulation automatisme No. 612, 23 octobre 1949, Paris ; pages 41-45).

La présente invention vise à fournir un dispositif de mesure de courant à shunt répondant mieux que ceux antérieurement connus aux exigences de la pratique, notamment en ce qu'il donne une précision élevée, fournit un signal de mesure du courant parcourant un conducteur sur une sortie dont le potentiel est totalement découplé de celui du conducteur, et reste d'un coût faible.

Dans ce but l'invention propose notamment un dispositif ayant un shunt, caractérisé en ce qu'il comporte un convertisseur tension-déphasage, relié aux bornes du shunt et fournissant deux signaux alternatifs dont le déphasage est représentatif de la tension, un coupleur optoélectronique d'isolement galvanique et de transmission des deux signaux et un convertisseur déphasage-tension fournissant une tension de sortie représentative du déphasage.

Le convertisseur tension-déphasage comporte avantageusement une boucle à verrouillage de phase ayant un déphaseur, un discriminateur de phase associé à une référence de tension, et un organe de calcul d'erreur. Dans une variante de réalisation, le convertisseur tension-déphasage est constitué d'une boucle à verrouillage de phase dans lequel le déphaseur est remplacé par un oscillateur commandé en tension. Dans un cas comme dans l'autre, le discriminateur de phase utilisé dans le convertisseur tension-déphasage peut être choisi identique à un discriminateur de phase appartenant au convertisseur déphasage-tension. Les deux convertisseurs peuvent alors utiliser des circuits fournissant une tension de référence identiques. La stabilité des facteurs d'échelle peut alors être assurée du fait que les circuits sont identiques, à condition qu'ils utilisent des tensions de référence stabilisées.

Le dispositif sera généralement complété par des filtres permettant d'éliminer ou du moins d'atténuer les signaux parasites et/ou d'assurer la stabilité, notamment en cas d'utilisation d'une boucle à verrouillage de phase.

Les coupleurs opto-électroniques, disponibles à bas prix, sont déjà largement utilisés pour isoler gal- vaniquement deux circuits. Mais leur emploi semblait à priori exclu pour la transmission d'un signal de mesure très variable, car ils manquent de précision et de linéarité et leurs caractéristiques évoluent dans le temps. L'incidence de ce défaut est éliminée, dans la mise en oeuvre de l'invention, du fait qu'on transforme la tension analogique prélevée aux bornes du shunt en un signal qu'on peut qualifier de binaire, le déphasage entre deux signaux alternatifs correspondant à l'intervalle de temps entre les passages à zéro des deux signaux, qui sont reproduits exactement par les coupleurs opto-électroniques, qui ont une vitesse de réponse élevée.

L'invention sera mieux comprise à la lecture de la description qui suit d'un mode particulier de réalisation et de variantes, donnés à titre d'exemples non limitatifs. La description se réfère aux dessins qui l'accompagnent, dans lesquels :
- la figure 1 est un schéma synoptique d'un mode particulier de réalisation ;
- la figure 2, similaire à une fraction de la figure 1, montre une variante de réalisation.

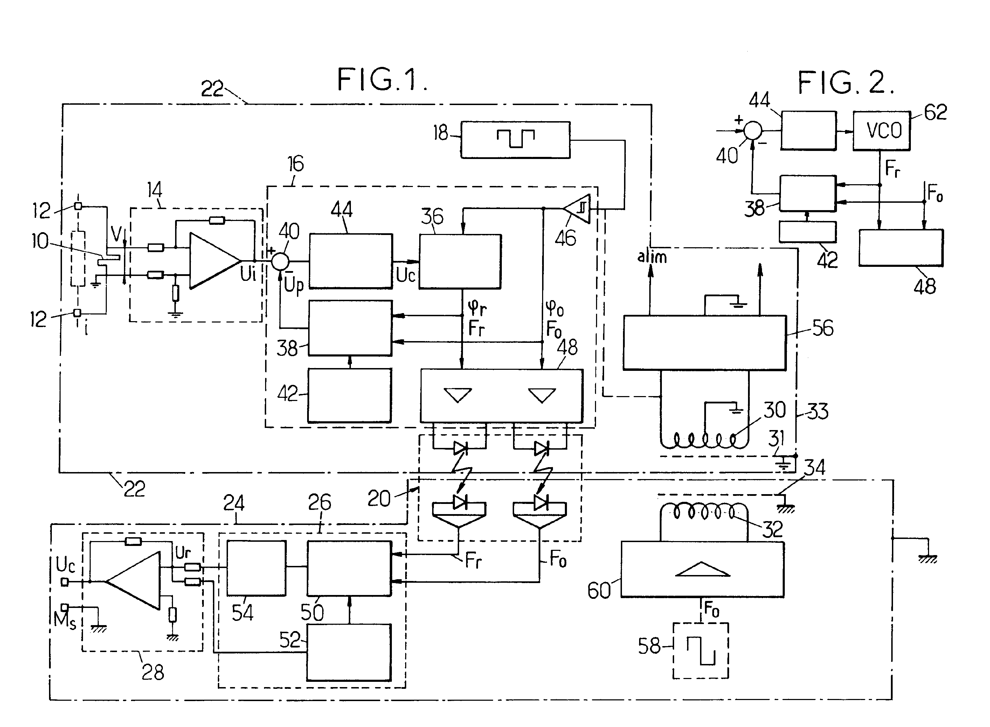

Le dispositif représenté en figure 1 est destiné à mesurer le courant I, continu ou alternatif, qui circule dans un circuit. Pour cela, un shunt 10, constitué par une résistance de valeur connue, est monté entre deux bornes 12 du circuit. Le courant i qui traverse le shunt représente une fraction déterminée du courant 1 et provoque l'apparition, aux bornes du shunt, d'une tension V représentative de I.

Le dispositif montré à titre d'exemple comprend un préamplificateur différentiel d'entrée 14, destiné à porter le signal V de sortie du shunt à un niveau suffisant pour un fonctionnement correct du convertisseur tension-déphasage 16 qui suit. Les caractéristiques du préamplificateur sont choisies en fonction de la dynamique d'intensité et de fréquence du courant à mesurer. Dans la pratique, on choisira un préamplificateur 14 dont la bande passante s'étend jusqu'à une fréquence au moins égale à dixfois la limite haute de la dynamique en fréquence du courant. En robotique, cela amènera généralement à choisir un préamplificateur 14 ayant une bande passante allant du continu jusqu'à 20 kHz environ.

Le convertisseur tension-déphasage est prévu pour fournir, sur sa sortie, deux signaux alternatifs ; en régime stabilisé, ces signaux ont des fréquences Fo de référence et Fr égales et leur déphasage <1>, - φₒ est une représentation linéaire de la tension d'entrée Ui. Dans le mode de réalisation illustré en figure 1, la fréquence Fr est fournie par un oscillateur local 18.

Un coupleur double opto-électronique 20 transmet les signaux entre les circuits "flottants" 22 du dispositif et les circuits 24 maintenus à basse tension. Ce coupleur double 20 restitue des signaux à fréquences Fr et Fo qui sont appliquées à un convertisseur déphasage-tension 26 qui reconstitue, sur sa sortie, une tension Ur représentative de la différence de phase (D, - (D, entre les signaux d'entrée et donc de V. Dans le cas illustré sur la figure 1, ce convertisseur est suivi d'un amplificateur 28 de choix d'échelle et de cadrage, qui fournit une tension de sortie Uc, par rapport à la terre M, représentative de V et donc du courant I.

Le dispositif est complété par des circuits d'alimentation. Lorsque, comme c'est généralement le cas, les circuits flottants 22 ne peuvent être alimentés directement à partir du circuit sur laquelle est effectuée la mesure, l'alimentation peut s'effectuer partir d'un réseau général, par l'intermédiaire d'un transformateur d'isolement. Dans le cas illustré sur la figure 1, ce transformateur d'isolement comporte un secondaire 30 et un écran 31. L'écran, un blindage 33 entourant la partie flottante et le point milieu du secondaire sont mis à la masse de la partie haute tension. Le primaire 32 du transformateur peut être séparé du secondaire 30 par un écran 34, qui, lui, est à la terre.

On décrira maintenant une constitution possible des différents sous-ensembles du dispositif de la figure 1.

Le convertisseur tension-déphasage 16, dont la fonction est de fournir deux signaux présentant une différence de phase φᵣ-φₒ représentative de la tension d'entrée Ui, peut comporter un déphaseur variable 36 qui, en régime établi, fournit un signal de sortie à fréquence Fr égale à la fréquence Fo du signal qu'il reçoit, avec un déphasage φᵣ-φₒ proportionnel à la tension Uc appliquée à son entrée et une boucle d'asservissement à verrouillage de phase. La boucle montrée en figure 1 comporte un discriminateur de phase 38 qui fournit une tension de contre-réaction Up proportionnelle à φᵣ₋ φₒ et l'applique sur l'entrée sous-tractive d'un additionneur 40 dont l'entrée additive reçoit Ui. Le facteur d'échelle du discriminateur de phase 38 est fixé par une référence de tension stabilisée 42. Un réseau correcteur 44 est avantageusement placé entre l'additionneur 40 et le déphaseurva- riable 36 pour assurer la stabilité du montage. Le signal à fréquence Fo fourni par l'oscillateur 18 est mis en forme par un étage 46.

Un circuit d'interface 48 est placé en amont du coupleur double opto-électronique 20 pour générer les courants nécessaires à l'alimentation des diodes électroluminescentes du coupleur 20.

Le coupleur est avantageusement constitué de deux diodes électroluminescentes et de deux photorécepteurs (photodiodes ou phototransistors par exemple) constitués sur une même puce pour avoir les mêmes caractéristiques et conserver le déphasage différentiel φᵣ- φₒ. On évite ainsi la nécessité de rechercher des composants ayant les mêmes caractéristiques.

Le convertisseur déphasage-tension 24 de la partie à basse tension comporte un discriminateurde phase 50 qui reçoit une tension de référence fournie par un générateur de référence stabilisé 52. Le générateur 52 sera avantageusement choisi identique au générateur 42 de façon à avoir le même comportement. Un filtre passe-bas 54 d'élimination des fréquence Fo et Fr est avantageusement placé en aval du discriminateur 50 de façon à atténuer le bruit superposé au signal utile.

L'amplificateur 28 de sortie permet d'obtenir l'échelle souhaitée et d'assurer le cadrage de la tension de sortie Uc par rapport à la terre ou à la masse du système et d'effectuer des réglages.

L'alimentation de la partie à basse tension 24 peut s'effectuer de façon classique. En revanche, il est important que la partie flottante 22 ait un blindage imposant aux lignes de champ électrique issues de la totalité des circuits qui y sont contenus de se refermer au potentiel du circuit de mesure du courant, afin de ne pas perturber la mesure, et cela d'autant plus que les variations de potentiel sont importantes. Pour ce motif, le transformateur d'alimentation utilise un écran 31 porté à la masse de la haute tension et un écran 34 mis à la terre. Les circuits d'alimentation flottants 56 ont eux-mêmes avantageusement un point milieu mis à la masse de la haute tension, c'est-à-dire au potentiel de l'écran 34. Ce dernier est porté à un potentiel représentatif de celui du shunt : c'est par exemple une des bornes du shunt qui peut représenter la masse de la partie flottante, comme le montre la figure 1.

Le dispositif est susceptible de nombreuses variantes de réalisation. Par exemple, comme le montre la figure 2, où les organes correspondant à ceux de la figure 1 portent le même numéro de référence, le déphaseur variable 36 est remplacé par un oscillateur 62 à commande par tension. Dans une autre variante de réalisation, la fréquence de référence Fo est prélevée sur le courant d'alimentation appliqué au circuit d'alimentation haute tension 56. Dans ce cas, la puissance totale nécessaire au fonctionnement du dispositif peut être fournie par un oscillateur 58 (représenté en tirets sur la figure 1 ) et un circuit amplificateur d'attaque 60 qui remplace le secteur. Le signal à fréquence Fo est alors amené à l'étage de mise en forme à partir du secondaire 30 (ligne en tirets sur la figure 1).

## Revendications

1. Dispositif de mesure de courant électrique, fournissant une tension de sortie proportionnelle au courant parcourant un conducteur, ayant un shunt (10), caractérisé en ce qu'il comprend : un convertisseur tension-déphasage (16) relié aux bornes du shunt et fournissant deux signaux alternatifs dont le déphasage est représentatif de la tension ; un coupleur opto-électronique (20) d'isolement galvanique et de transmission des deux signaux ; et un convertisseur déphasage-tension (26) fournissant une tension de sortie représentative du déphasage.

2. Dispositif selon la revendication 1, caractérisé en ce que le convertisseur tension-déphasage comporte une boucle à verrouillage de phase ayant un déphaseur (36) commandé, un discriminateur de phase (38) associé à une référence de tension (42), et un organe de calcul d'erreur (40) tel qu'un soustracteur.

3. Dispositif selon la revendication 1, caractérisé en ce que le convertisseur tension-déphasage (16) est constitué d'une boucle à verrouillage de phase ayant un oscillateur (62) commandé par la tension aux bornes du shunt, un discriminateur de phase (38) associé à une référence de tension (42) et un organe de calcul d'erreur, tel qu'un soustracteur.

4. Dispositif selon la revendication 2 ou 3, caractérisé en ce que la boucle contient un réseau correcteur (44).

5. Dispositif selon l'une quelconque des revendications 2 à 4, caractérisé en ce que le convertisseur déphasage-tension comporte un discriminateur de phase (50) et une référence de tension (52) identiques à ceux du convertisseur tension-déphasage.

6. Dispositif selon la revendication 2 ou l'une quelconque des revendications qui en dépendent, caractérisé en ce que le déphaseur est alimenté par un signal à fréquence porteuse prédéterminée obtenu par mise en forme d'un prélèvement sur le secondaire (30) d'un transformateur d'alimentation des parties du circuit dont le potentiel flotte avec celui du shunt.

7. Dispositif selon la revendication 2 ou l'une quelconque des revendications qui en dépendent, caractérisé en ce qu'il comporte un oscillateur local (18) à fréquence prédéterminée et un circuit (46) de mise en forme du signal de l'oscillateur local, alimentant le convertisseur.

8. Dispositif selon l'une quelconque des revendications précédentes, caractérisé en ce que les composants portés à un potentiel flottant avec celui du shunt sont contenus dans un blindage (33) porté à un potentiel représentatif de celui du shunt (10).

9. Dispositif selon l'une quelconque des revendications précédentes, caractérisé en ce que la puissance d'alimentation du circuit est fournie par un oscillateur local (58) ou par le réseau de distribution d'électricité à travers un transformateur dont le primaire et le secondaire sont munis d'écrans (34,33) de blindage.
